# EUROPÄISCHE PATENTSCHRIFT

(11) **EP 0 583 688 B1**
(45) Veröffentlichungstag und Bekanntmachung des Hinweises auf die Patenterteilung: **29.12.1997**
(21) Anmeldenummer: 93112507.4
(22) Anmeldetag: 04.08.1993
(51) Int. Cl.: H03K 17/60, H03K 17/14, H03K 19/00, H03K 19/003

(54) **Digitaler Stromschalter**
Digital current switch
Commutateur numérique de courant

(30) Priorität: 18.08.1992 DE 4227282
(43) Veröffentlichungstag der Anmeldung: 23.02.1994
(73) Patentinhaber: SIEMENS AKTIENGESELLSCHAFT, 80333 München (DE)
(72) Erfinder: Schlachter, Hans-Heiner, Dipl.-Ing., D-82061 Neuried (DE)

(56) Entgegenhaltungen:
- EP-A- 0 117 180
- EP-A- 0 249 521
- WO-A-94/01936
- CA-A- 2 057 824
- DE-A- 1 800 207

## Beschreibung

Die Erfindung betrifft einen digitalen Stromschalter nach dem Oberbegriff des Anspruchs 1. Eine solche Schaltung ist aus CA-A-2 057 824 bekannt.

Schaltungen mit den Merkmalen a) bis d) des Oberbegriffs des Anspruchs 1 sind aus der europäischen Offenlegungsschrift EP 0 436 823 bekannt. Werden bipolare Transistoren als Schalttransistoren verwendet, bezeichnet man diese Schaltungstechnik als CML-(Current Mode Logic-) Technik, wenn der Ausgang unmittelbar mit dem Arbeitswiderstand verbunden ist, und von ECL-(Emitter Coupled Logic-)Technik, wenn der Ausgang über einen Emitterfolger mit dem Arbeitswiderstand verbunden ist. Der Ausgang der Schaltstufe ist im allgemeinen durch eine Kapazität belastet. Diese setzt sich im wesentlichen aus den parasitären Kapazitäten der Schalttransistoren, der Eingangstransistoren nachgeschalteter Schaltstufen und der Verbindungsleitung zusammen. Während eines Schaltvorganges wird die Kapazität umgeladen. Der Ladestrom fließt entweder über den Arbeitswiderstand bzw. Emitterfolgertransistor oder über die Stromquelle des Stromschalters bzw. die Stromquelle des Emitterfolgers. Diese Schaltungen werden üblicherweise als integrierte Schaltungen hergestellt. Die absoluten Kenndaten der Bauelemente weisen dabei einen relativ weiten Schwankungsbereich auf. Außerdem sind die Transistorparameter, z.B. Stromverstärkung und Basis-Emitter-Spannung, relativ stark temperaturabhängig. Somit sind die am Ausgang der Schaltstufe gelieferten bzw. aufgenommenen Ströme zum Umladen der parasitären Kapazitäten prozeß- und temperaturabhängig. Die Schaltungen werden deshalb bisher zur Erzielung der geforderten Geschwindigkeitsanforderungen nach den ungünstigst möglichen Bedingungen dimensioniert. Dies bedeutet, daß zur Erzielung eines vorgegebenen Pegelhubs am Arbeitswiderstand der Wert des Widerstandes niedrig, dafür aber der von der Stromquelle des Stromschalters bzw. des Emitterfolgertransistors eingeprägte Strom groß bemessen wird. Dies hat den Nachteil, daß die Verlustleistung bei normalen Betriebsbedingungen relativ hoch ist.

Der Erfindung liegt die Aufgabe zugrunde, eine digitale Stromschalterstufe anzugeben, die über einen großen Bereich von Versorgungsspannungen zuverlässig betrieben werden kann.

Diese Aufgabe wird mit den in den unabhängigen Ansprüchen 1 und 2 definierten Merkmalen gelöst.

Die Erfindung wird im folgenden anhand der in der Zeichnung dargestellten Figuren näher erläutert.

Es zeigen
- Figur 1: einen erfindungsgemäßen Stromschalter mit einer Regelung,
- Figur 2: eine weitere Ausführung der Regelung und
- Figur 3: eine schaltungstechnische Realisierung der Regelung der Figur 2.

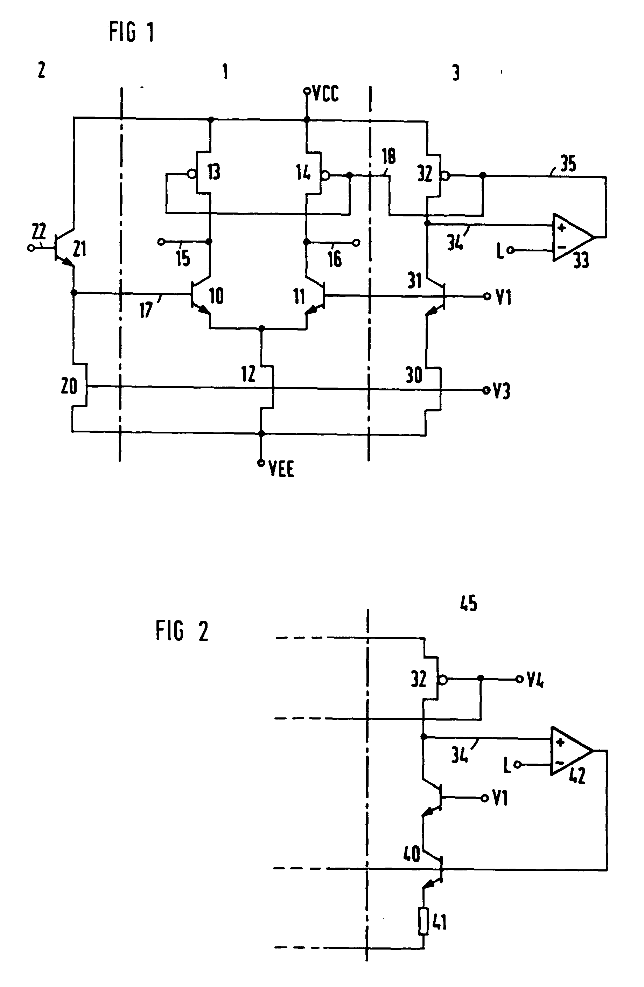

Die Schaltstufe der Figur 1 enthält drei Schaltungsabschnitte 1, 2, 3. Zur Erläuterung des Funktionsprinzips wird zunächst auf den Schaltungsabschnitt 1 Bezug genommen. Der Schaltungsabschnitt 2 enthält eine vorteilhafte Weiterbildung der Erfindung.

Der Schaltungsabschnitt 1 enthält einen Stromschalter mit zwei emittergekoppelten Bipolartransistoren 10, 11, deren Emitter über eine steuerbare Stromquelle mit einem Anschluß für ein Versorgungspotential VEE verbunden sind. Die gesteuerte Stromquelle ist als N-MOS-Transistor 12 ausgeführt, dessen Gate-Anschluß ein Anschluß für ein Steuerpotential V3 ist. Die Kollektoren der Bipolartransistoren 10, 11 sind über je einen steuerbaren Arbeitswiderstand mit einem Anschluß für ein Versorgungspotential VCC verbunden. Als steuerbare Widerstände sind je ein P-MOS-Transistor 13, 14 verwendet, deren Gate-Anschlüsse als ein Anschluß 18 für ein weiteres Steuerpotential dienen. Die Kollektoren der Bipolartransistoren 10, 11 weisen je einen Ausgangssignalanschluß 15, 16 auf. Die Ausgangssignalanschlüsse 15, 16 führen komplementäre Signalpegel. Die Basis des Bipolartransistors 10 ist ein Anschluß 17 für ein Eingangssignal, die Basis des Bipolartransistors 11 wird von einem Referenzsignal V1 gesteuert.

Liegt am Eingangssignalansachluß 17 ein H-Pegel an, ist der Transistor 10 leitend, der Transistor 11 gesperrt. Der von der Stromquelle 12 eingeprägte Strom fließt durch den P-MOS-Transistor 13, der P-MOS-Transistor 14 ist stromlos. Am Ausgang 15 liegt dann ein L-Pegel, am Ausgang 16 ein H-Pegel an. Bei einem L-Pegel am Eingang 17 ist der Bipolartransistor 10 gesperrt, während der Bipolartransistor 11 leitend ist. Am Ausgang 16 stellt sich ein L-Pegel ein, am Ausgang 15 ein H-Pegel.

Der N-MOS-Transistor 12 ist mit seinem Source-Anschluß an das in bezug auf das Versorgungspotential VCC negative Versorgungspotential VEE angeschlossen. Durch Einstellung des Potentials V3 wird die Gate-Source-Spannung des N-MOS-Transistors 12 und somit sein Drain-Strom festgelegt. Der N-MOS-Transistor 12 arbeitet folglich als einstellbare Stromquelle. Die P-MOS-Transistoren 13, 14 sind jeweils mit ihrem Source-Anschluß an das Versorgungspotential VCC gelegt.

Durch Einstellung des am Anschluß 18 anliegenden Potentials wird der Widerstand der Drain-Source-Strecken der P-MOS-Transistoren 13, 14 festgelegt. Die P-MOS-Transistoren 13, 14 wirken folglich als einstellbare Widerstände.

Der L-Pegel an den Ausgängen 15, 16 wird durch den Spannungsabfall an den P-MOS-Transistoren 13 bzw. 14 bewirkt, den der durch den N-MOS-Transistor 12 eingeprägte Strom je nach Schaltzustand des Stomschalters an dem betreffenden P-MOS-Transistor bewirkt. Ein H-Pegel liegt dann vor, wenn der betreffende Transistor stromlos ist. Das Potential V3 und das Potential am Anschluß 18 werden so eingestellt, daß der Spannungsabfall am jeweils stromdurchflossenen der PMOS-Transistoren 13, 14 bezogen auf das Versorgungspotential VCC bei verschiedenen Einstellungen gleich dem Wert ist, der für einen L-Pegel festgelegt wurde. Dies bezieht sich auf den Ruhezustand der Schaltstufe. Wird beispielsweise das Potential V3 niedrig gewählt, ist der vom N-MOS-Transistor 12 eingeprägte Strom niedrig. Das Potential am Anschluß 18 muß deshalb entsprechend hoch gewählt werden, so daß der Widerstandswert der Drain-Source-Strecken der P-MOS-Transistoren 13, 14 hoch ist und damit der L-Pegel an den Ausgängen 15 bzw. 16 gleich bleibt.

Die Ausgänge 15, 16 sind durch nachgeschaltete Schaltstufen kapazitiv belastet. Die Geschwindigkeit zum Be- und Entladen dieser Kapazitäten wird durch die an den Ausgängen 15, 16 lieferbaren bzw. aufnehmbaren Strömen bestimmt. Diese werden durch den Widerstandswert der Drain-Source-Strecken der P-MOS-Transistoren 13, 14 bzw. dem von der gesteuerten, vom N-MOS-Transistor 12 gebildeten Stromquelle festgelegt. Die Parameter dieser Bauelemente hängen jedoch von der Betriebstemperatur ab. Außerdem können die Parameter zweier Schaltstufen, die auf verschiedenen integrierten Bauelementen angeordnet sind, aufgrund von Schwankungen des Herstellungsprozesses teilweise erheblich voneinander abweichen. Die Stromtreiber- bzw. Stromaufnahmefähigkeit der Ausgänge 15, 16 kann erfindungsgemäß über das Potential V3 und das am Anschluß 18 anliegende Potential für jede Schaltstufe kontinuierlich eingestellt werden. Dadurch ergibt sich der Vorteil, daß der durch die gesteuerte Stromquelle eingeprägte Strom so niedrig gewählt werden kann, daß die Geschwindigkeitsanforderungen gerade noch erfüllt sind. Die Verlustleistung einer erfindungsgemäßen Schaltstufe kann somit unter Berücksichtigung von temperaturbedingten und prozeßtechnischen Schwankungen möglichst niedrig gewählt werden.

Im Schaltungsabschnitt 3 der Figur ist eine Regeleinrichtung gezeigt, mit der bei vorgebbarem Steuerpotential V3 das entsprechende Potential für den Anschluß 18 erzeugt wird, so daß der L-Pegel an den Ausgängen 15, 16 gleich bleibt. Hierzu wird an einem Ausgang 34 einer Referenzschaltung ständig ein L-Pegel erzeugt. Dieser L-Pegel wird mit einem vorgebbaren Pegel L in einer Vergleichereinrichtung 33 verglichen. Ein Ausgang 35 der Vergleichereinrichtung wird in die Referenzschaltung derart eingekoppelt, daß der an ihrem Ausgang 34 vorliegende Pegel auf den vorgebbaren Pegel L ausgeregelt wird. Als Referenzschaltung ist eine Schaltung vorgesehen, die einem Stromschalter entspricht, der ständig einen L-Pegel erzeugt.

Die Referenzschaltung enthält einen P-MOS-Transistor 32, dessen Source-Anschluß mit dem Versorgungspotential VCC, dessen Gate-Anschluß mit dem Ausgang 35 der Vergleichereinrichtung 33 und dessen Drain-Anschluß mit dem Ausgang 34 der Referenzschaltung verbunden ist. Ein Bipolartransistor 31 (der gegebenenfalls auch weggelassen werden kann) ist mit seinem Kollektor-Anschluß mit dem Drain-Anschluß des P-MOS-Transistors 32 verbunden. Sein Emitter ist über die Drain-Source-Strecke eines N-MOS-Transistors 30 mit dem Anschluß für das Versorgungspotential VEE verbunden. Der Gate-Anschluß des N-MOS-Transistors 30 wird entsprechend dem Stromquellentransistor 12 der Schaltstufe vom Potential V3 gesteuert. Die Basis des Bipolartransistors 31 ist entsprechend dem Bipolartransistor 11 ein Anschluß für das Potential V1. Als Vergleichereinrichtung 33 wird vorzugsweise ein Operationsverstärker verwendet.

Das Potential V3 wird nun so eingestellt, daß die Geschwindigkeitsanforderungen an die im Schaltungsabschnitt 1 gezeigte Schaltstufe erfüllt sind. Vorteilhafterweise wird ein temperaturabhängiges Steuerpotential V3 verwendet, so daß temperaturabhängige Änderungen der Bauelementeparameter möglichst ausgeglichen werden. Die Vergleichereinrichtung 33 ist derart dimensioniert, daß an ihrem Ausgang 35 ein Signal erzeugt wird, durch das der P-MOS-Transistor 32 solange nachgestellt wird, bis der am Ausgang 34 anliegende Pegel gleich dem vorgebbaren Pegel L ist. Der Anschluß 35 ist außerdem mit dem Anschluß 18 der Schaltstufe verbunden, so daß die an den Ausgängen 15 bzw. 16 anliegenden L-Signale gleich dem vorgebbaren Pegel L sind. Der vorgebbare Pegel L kann beispielsweise über ein Anschlußpad in die integrierte Schaltung eingespeist werden oder durch geeignete Schaltungsmaßnahmen auf der integrierten Schaltung selbst erzeugt werden.

Damit die Sättigung des Bipolartransistors 10 bei einem L-Pegel am Ausgang 15 vermieden wird, sind die Eingangssignalpegel am Anschluß 17 bezüglich der Ausgangssignalpegel am Ausgang 15 zum Versorgungspotential VEE hin verschoben. Dies wird durch eine im Schaltungsabschnitt 2 gezeigte Anordnung erreicht. Sie enthält einen Bipolartransistor 21, dessen Kollektor mit dem Anschluß für das Versorgungspotential VCC und dessen Emitter mit dem Anschluß 17 und über einen N-MOS-Transistor 20 mit dem Anschluß für das Versorgungspotential VEE verbunden ist. Der Gate-Anschluß des N-MOS-Transistors 20 wird vom Potential V3 gesteuert. Die Basis des Bipolartransistors 21 ist mit einem Anschluß 22 für ein weiteres Eingangssignal verbunden. Die Signalpegel am Anschluß 22 haben die gleichen L- und H-Pegelwerte wie die Pegel an den Ausgängen 15, 16.

In der Zeichnung ist zur Erzielung einer minimalen Verlustleistung der Schaltung nur das Potential V3 einstellbar. Das Potential für den Anschluß 18 wird über die Teilschaltung 3 erzeugt. Das Potential am Anschluß 18 kann beispielsweise auch über ein Eingangspad der integrierten Schaltung als einstellbares Potential zugeführt werden.

Das Referenzpotential V1 liegt idealerweise in der Mitte des am Anschluß 17 anliegenden Signalpegels. Es ist auch denkbar, daß die Basis des Bipolartransistors 11 von einem Signal gesteuert wird, das dem am Eingang 17 anliegenden Signal komplementär ist. Die Basis des Bipolartransistors 31 kann dann vom Referenzpotential V1, vorzugsweise aber von einem logischen H-Pegel gesteuert werden.

Die im Schaltungsabschnitt 1 gezeigte Schaltstufe enthält bipolare Schalttransistoren 10, 11. Es ist auch möglich, MOS-Transistoren als Schalttransistoren zu verwenden. Anstelle der Bipolartransistoren 10, 11, 31 werden dann P-MOS-Transistoren oder N-MOS-Transistoren verwendet. Da bei MOS-Transistoren keine Sättigung auftritt, kann dann auf eine Schaltung zur Pegelverschiebung gemäß dem Schaltungsabschnitt 2 verzichtet werden.

Das Ausführungsbeispiel der Figur 1 zeigt in jedem der Kollektorkreise der Schalttransistoren 10, 11 je einen als P-MOS-Transistor 13, 14 ausgeführten Lastwiderstand. Es ist möglich, im Kollektorkreis nur eines der Schalttransistoren 10, 11 einen steuerbaren Arbeitswiderstand anzuordnen. Es steht dann nur einer der Ausgänge 15 bzw. 16 zur Verfügung.

Die bisherigen Beispiele betreffen Stromschalter in CML-Technik. Die Erfindung ist auch für Schaltungen in ECL-Technik anwendbar. Hierzu ist den Ausgängen 15, 16 je ein Emitterfolgertransistor nachgeschaltet, dessen Basis mit den Ausgängen 15, 16, dessen Kollektor mit dem Anschluß für das Versorgungspotential VCC und dessen Emitter über eine steuerbare Stromquelle, vorzugsweise in Form eines N-MOS-Transistors, dessen Gate-Anschluß vom Potential V3 gesteuert wird, mit dem Anschluß für das Versorgungspotential VEE verbunden ist.

In der Figur 2 ist eine weitere Ausführungsform der Referenzschaltung und der Vergleichereinrichtung gezeigt. Der Referenzstromzweig enthält eine gesteuerte Stromquelle, die als Bipolartransistor 40 mit einem emitterseitigen Widerstand 41 ausgeführt ist. In gleicher Weise können die Stromquellen des Stromschalters und die zu den Emitterfolgertransistoren gehörenden Stromquellen, die dem Ausgang des Stromschalters nachgeschaltet bzw. den Eingängen vorgeschaltet sind, als Bipolartransistoren mit emitterseitigem Widerstand ausgeführt werden. Eine Vergleichereinrichtung 42 ist nun mit ihrem Ausgang mit dem Steuereingang der im Referenzstromzweig angeordneten steuerbaren Stromquellen, also dem Basisanschluß des Bipolartransistors 40, verbunden. Der Referenzstromzweig ist über das Potential V3, das an den Gate-Anschluß des MOS-Transistors 32 gelegt ist, steuerbar. Über die Vergleichereinrichtung 42 wird die steuerbare Stromquelle derart nachgestellt, daß der L-Pegel am Anschluß 34 gleich dem vorgebbaren Pegel L an einem der Eingänge der Vergleichereinrichtung 42 ist.

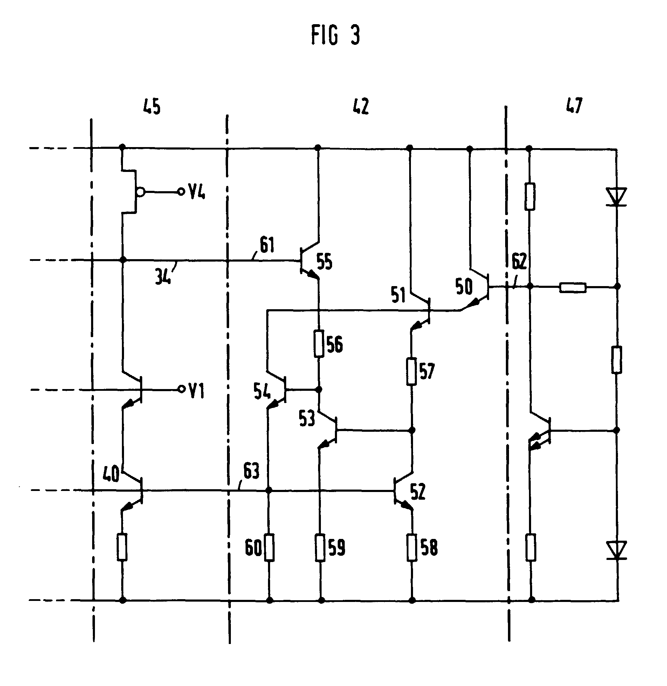

Eine Ausführungsform der Vergleichereinrichtung 42 und eine Anordnung zur Erzeugung des vorgebbaren Pegels L ist in Figur 3 gezeigt. Der Pegel L wird mittels einer bekannten, temperaturkompensierten Spannungskonstantschaltung 47, die üblicherweise als Band Gap-Reference bezeichnet wird, erzeugt. An einem Anschluß 62 liegt dann eine temperaturkompensierte Konstantspannung vor. Der Anschluß 62 ist mit einem der Eingänge der Vergleichereinrichtung 42 verbunden, der andere der Eingänge 61 ist mit dem Anschluß 34 verbunden. Der Ausgang 63 der Vergleichereinrichtung 42 ist mit der Basis des Bipolartransistors 40 verbunden. Durch die Vergleichereinrichtung 42 wird das Steuersignal am Ausgang 63 derart erzeugt, daß der Pegel am Eingang 61 gleich dem vorgebbaren Pegel am Eingang 62 ist.

Die Vergleichereinrichtung 42 enthält einen Transistor 50, der in Emitterfolgerschaltung bezüglich des Anschlusses 62 geschaltet ist. Ein Transistor 51 ist in Emitterfolgerschaltung bezüglich des Emitters des Transistors 50 geschaltet. Der Emitter des Transistors 51 ist über einen Widerstand 57 mit dem Kollektor eines Transistors 52 verbunden, dessen Emitter über einen Widerstand 58 mit dem Anschluß für das Versorgungspotential VEE verbunden ist. Der Kollektor des Transistors 52 ist mit der Basis eines Transistors 53 verbunden, dessen Kollektor über einen Widerstand 56 mit dem Emitter eines Transistors 55 verbunden ist, der in Emitterfolgerschaltung bezüglich des Eingangs 61 geschaltet ist. Der Emitter des Transistors 53 ist über einen Widerstand 59 mit dem Anschluß für das Versorgungspotential VEE verbunden. Der Kollektor des Transistors 53 ist mit der Basis eines Transistors 54 verbunden, dessen Kollektor mit dem Emitter des Transistors 50 und dessen Emitter über einen Widerstand 60 mit dem Anschluß für das Versorgungspotential VEE verbunden ist. Die Basis des Transistors 52 ist mit dem Emitter des Transistors 54 und dem Ausgang 63 verbunden.

Die Widerstände 57, 58 sowie die Widerstände 56, 59 haben vorzugsweise die gleichen Widerstandswerte. Die Basis-Emitter-Spannungen der Transistoren 55, 53 bzw. 54, 50 bzw. 52, 51 sind jeweils gleich, da durch sie jeweils der gleiche Strom fließt. Die Spannung längs des Pfades aus der Basis-Emitter-Strecke des Transistors 55, dem Widerstand 56, der Basis-Emitter-Strecke des Transistors 54, der Basis-Emitter-Strecke des Transistors 52 und dem Widerstand 58 ist gleich der Spannung längs des Pfades aus dem Anschluß 62, der Basis-Emitter-Strecke des Transistors 50, der Basis-Emitter-Strecke des Transistors 51, dem Widerstand 57, der Basis-Emitter-Strecke des Transistor 53 und dem Widerstand 59, wobei die oben angegebenen Bedingungen berücksichtigt sind. Somit stellt sich am Ausgang 63 jeweils der Pegel ein, der notwendig ist, um den Pegel am Eingang 61 gleich dem eingeprägten, temperaturkompensierten Pegel am Eingang 62 zu halten.

## Patentansprüche

1. Digitaler Stromschalter mit den Merkmalen:
(a) mindestens ein erster und ein zweiter Transistor (10,11) sind am ersten Anschluß jedes Hauptstrompfades gekoppelt und über eine erste steuerbare Stromquelle (12) mit einem Anschluß für ein erstes Versorgungspotential (VEE) verbunden,
(b) der Steuereingang des ersten Transistors (10) ist ein Anschluß (17) für ein Eingangssignal, der Steuereingang des zweiten Transistors (11) ein Anschluß für ein Referenzsignal (V1),
(c) die zweiten Anschlüsse der Hauptstrompfade der Transistoren (10, 11) sind mit einem Anschluß für ein zweites Versorgungspotential (VCC) verbunden,
(d) der zweite Anschluß des Hauptstrompfades mindestens eines der Transistoren (10; 11) ist mit einem Ausgangssignalanschluß (15; 16) und über einen Widerstand (13; 14) mit dem Anschluß für das zweite Versorgungspotential (VCC) verbunden,
(e) der Widerstand ist ein erster steuerbarer Widerstand, und
(f) ein Referenzstromzweig ist vorhanden, der einen zweiten steuerbaren Widerstand (32) und eine zweite steuerbare Stromquelle (30) enthält, wobei ein erster Anschluß des zweiten steuerbaren Widerstandes (32) mit dem Anschluß für das zweite Versorgungspotential (VCC) und ein erster Anschluß der zweiten steuerbaren Stromquelle (30) mit dem Anschluß für das erste Versorgungspotential (VEE) verbunden ist, wobei ein zweiter Anschluß des zweiten steuerbaren Widerstandes (32) mit einem zweiten Anschluß der zweiten steuerbaren Stromquelle (30) gekoppelt ist und ein Vergleicher (33) vorhanden ist, dessen erster Eingang (+) mit dem zweiten Anschluß des zweiten steuerbaren Widerstandes (32) verbunden ist, dessen zweiter Eingang (-) ein Anschluß für ein Vergleichspotential (L) ist und dessen Ausgang (35) mit einem Steuereingang (18) jedes des ersten und zweiten steuerbaren Widerstands (32, 13; 32, 14) verbunden ist,
so daß der Wert des ersten steuerbaren Widerstandes (13;14) in Abhängigkeit vom Strom der ersten Stromquelle (12) derart gesteuert wird, daß mit abnehmenden Strom der ersten Stromquelle der Widerstandswert zunimmt und umgekehrt, so daß der Spannungsabfall am ersten steuerbaren Widerstand im Ruhezustand des Stromschalters gleich einem vorgegebenen Wert ist,
dadurch gekennzeichnet, daß ein weiterer Transistor (31) mit seinem Hauptstrompfad zwischen dem zweiten Anschluß der zweiten steuerbaren Stromquelle (30) und dem zweiten Anschluß des zweiten steuerbaren Widerstandes (32) gekoppelt ist, wobei der Steuereingang des weiteren Transistors (31) ein Anschluß für das Referenzsignal (V1) ist.

2. Digitaler Stromschalter mit den Merkmalen:
(a) mindestens ein erster und ein zweiter Transistor (10,11) sind am ersten Anschluß jedes Hauptstrompfades gekoppelt und über eine erste steuerbare Stromquelle (12) mit einem Anschluß für ein erstes Versorgungspotential (VEE) verbunden,
(b) der Steuereingang des ersten Transistors (10) ist ein Anschluß (17) für ein Eingangssignal, der Steuereingang des zweiten Transistors (11) ein Anschluß für ein Referenzsignal (V1),
(c) die zweiten Anschlüsse der Hauptstrompfade der Transistoren (10, 11) sind mit einem Anschluß für ein zweites Versorgungspotential (VCC) verbunden,
(d) der zweite Anschluß des Hauptstrompfades mindestens eines der Transistoren (10, 11) ist mit einem Ausgangssignalanschluß (15, 16) und über einen Widerstand (13, 14) mit dem Anschluß für das zweite Versorgungspotential (VCC) verbunden,
(e) der Widerstand ist ein erster steuerbarer Widerstand, und
(f) ein Referenzstromzweig ist vorhanden, der einen zweiten steuerbaren Widerstand (32), einen weiteren Transistor (31) und eine zweite steuerbare Stromquelle (40, 41) enthält, wobei der Steuereingang des weiteren Transistors (31) ein Anschluß für das Referenzsignal (V1) ist, wobei ein erster Anschluß des zweiten steuerbaren Widerstandes (32) mit dem Anschluß für das zweite Versorgungspotential (VCC) und ein erster Anschluß der zweiten steuerbaren Stromquelle (40, 41) mit dem Anschluß für das erste Versorgungspotential (VEE) verbunden ist, wobei ein zweiter Anschluß des zweiten steuerbaren Widerstandes (32) über den weiteren Transistor (31) mit einem zweiten Anschluß der zweiten steuerbaren Stromquelle (40, 41) gekoppelt ist und ein Vergleicher (42) vorhanden ist, dessen erster Eingang (+) mit dem zweiten Anschluß des zweiten steuerbaren Widerstandes (32) verbunden ist, dessen zweiter Eingang (-) ein Anschluß für ein Vergleichspotential (L) ist und dessen Ausgang mit einem Steuereingang jeder der ersten und zweiten steuerbaren Stromquellen (12, 40, 41) verbunden ist, so daß der Wert des ersten Widerstandes (13, 14) und der Strom der ersten Stromquelle (12) derart voneinander abhängig gesteuert werden, daß mit abnehmendem Wert des ersten Widerstandes der Strom der ersten Stromquelle zunimmt und umgekehrt, so daß der Spannungabfall am ersten Widerstand im Ruhezustand des Stromschalters gleich einem vorgegebenen Wert ist.

3. Digitaler Stromschalter nach Anspruch 1 oder 2, **dadurch gekennzeichnet,** daß der Anschluß für das Vergleichspotential (-) des Vergleichers (33; 42) mit dem Ausgang einer temperaturkompensierten Spannungskonstantschaltung (47) verbunden ist.

4. Digitaler Stromschalter nach einem der Ansprüche 1 bis 3, **dadurch gekennzeichnet,** daß die Transistoren (10, 11, 31) bipolare Transistoren sind.

5. Digitaler Stromschalter nach einem der Ansprüche 1 bis 4, **dadurch gekennzeichnet,** daß die steuerbaren Widerstände MOS-Transistoren (13, 14, 32) von einem ersten Kanaltyp sind.

6. Digitaler Stromschalter nach Anspruch 5, **dadurch gekennzeichnet,** daß die steuerbaren Stromquellen MOS-Transistoren (20, 12, 30) von einem zweiten, zum ersten Kanaltyp komplementären Kanaltyp sind.

7. Digitaler Stromschalter nach einem der Ansprüche 1 bis 6, **dadurch gekennzeichnet,** daß die steuerbaren Stromquellen bipolare Transistoren (40) mit emitterseitigem Widerstand (41) sind.

## Claims

1. Digital current switch having the features:
(a) at least one first and one second transistor (10, 11) are coupled at the first terminal of each main current path and are connected via a first controllable current source (12) to a terminal for a first supply potential (VEE),
(b) the control input of the first transistor (10) is a terminal (17) for an input signal, and the control input of the second transistor (11) is a terminal for a reference signal (V1),
(c) the second terminals of the main current paths of the transistors (10, 11) are connected to a terminal for a second supply potential (VCC),
(d) the second terminal of the main current path of at least one of the transistors (10; 11) is connected to an output signal terminal (15; 16) and, via a resistor (13; 14), to the terminal for the second supply potential (VCC),
(e) the resistor is a first controllable resistor, and
(f) a reference current path containing a second controllable resistor (32) and a second controllable current source (30) is present, a first terminal of the second controllable resistor (32) being connected to the terminal for the second supply potential (VCC), and a first terminal of the second controllable current source (30) being connected to the terminal for the first supply potential (VEE), a second terminal of the second controllable resistor (32) being coupled to a second terminal of the second controllable current source (30), and a comparator (33) being present, the first input (+) of which comparator is connected to the second terminal of the second controllable resistor (32), the second input (-) of which comparator is a terminal for a comparison potential (L) and the output (35) of which comparator is connected to a control input (18) of each of the first and second controllable resistors (32, 13; 32, 14), with the result that the value of the first controllable resistor (13; 14) is controlled as a function of the current of the first current source (12) in such a way that the resistance increases as the current of the first current source decreases, and vice versa, with the result that the voltage drop across the first controllable resistor in the quiescent state of the current switch is equal to a predetermined value,
characterized in that a further transistor (31) is coupled with its main current path between the second terminal of the second controllable current source (30) and the second terminal of the second controllable resistor (32), the control input of the further transistor (31) being a terminal for the reference signal (V1).

2. Digital current switch having the features:
(a) at least one first and one second transistor (10, 11) are coupled at the first terminal of each main current path and are connected via a first controllable current source (12) to a terminal for a first supply potential (VEE),
(b) the control input of the first transistor (10) is a terminal (17) for an input signal, and the control input of the second transistor (11) is a terminal for a reference signal (V1),
(c) the second terminals of the main current paths of the transistors (10, 11) are connected to a terminal for a second supply potential (VCC),
(d) the second terminal of the main current path of at least one of the transistors (10, 11) is connected to an output signal terminal (15, 16) and, via a resistor (13, 14), to the terminal for the second supply potential (VCC),
(e) the resistor is a first controllable resistor, and
(f) a reference current path containing a second controllable resistor (32), a further transistor (31) and a second controllable current source (40, 41) is present, the control input of the further transistor (31) being a terminal for the reference signal (V1), a first terminal of the second controllable resistor (32) being connected to the terminal for the second supply potential (VCC), and a first terminal of the second controllable current source (40, 41) being connected to the terminal for the first supply potential (VEE), a second terminal of the second controllable resistor (32) being coupled via the further transistor (31) to a second terminal of the second controllable current source (40, 41), and a comparator (42) being present, the first input (+) of which comparator is connected to the second terminal of the second controllable resistor (32), the second input (-) of which comparator is a terminal for a comparison potential (L) and the output of which comparator is connected to a control input of each of the first and second controllable current sources (12, 40, 41), with the result that the value of the first resistor (13, 14) and the current of the first current source (12) are controlled as a function of one another in such a way that the current of the first current source increases as the value of the first resistor decreases, and vice versa, with the result that the voltage drop across the first resistor in the quiescent state of the current switch is equal to a predetermined value.

3. Digital current switch according to Claim 1 or 2, characterized in that the terminal for the comparison potential (-) of the comparator (33; 42) is connected to the output of a temperature-compensated constant-voltage circuit (47).

4. Digital current switch according to one of Claims 1 to 3, characterized in that the transistors (10, 11, 31) are bipolar transistors.

5. Digital current switch according to one of Claims 1 to 4, characterized in that the controllable resistors are MOS transistors (13, 14, 32) of a first channel type.

6. Digital current switch according to Claim 5, characterized in that the controllable current sources are MOS transistors (20, 12, 30) of a second channel type which is complementary to the first channel type.

7. Digital current switch according to one of Claims 1 to 6, characterized in that the controllable current sources are bipolar transistors (40) having a resistor (41) on the emitter side.

## Revendications

1. Commutateur numérique de courant présentant les caractéristiques suivantes :
(a) au moins un premier et un second transistors (10, 11) sont couplés à la première borne de chaque trajet de courant principal et sont reliés par l'intermédiaire d'une première source (12) de courant commandée à une borne pour un premier potentiel (VEE) d'alimentation,
(b) l'entrée de commande du premier transistor (10) est une borne (17) pour un signal d'entrée, l'entrée de commande du deuxième transistor (11) est une borne pour un signal (V1) de référence,
(c) les secondes bornes des trajets de courant principaux des transistors (10, 11) sont reliées à une borne pour un second potentiel (VCC) d'alimentation,
(d) la seconde borne du trajet de courant principal de l'un au moins des transistors (10 ; 11) est reliée à une borne (15 ; 16) de signal de sortie et par l'intermédiaire d'une résistance (13 ; 14) à la borne pour le second potentiel (VCC) d'alimentation,
(e) la résistance est une première résistance pouvant être commandée, et
(f) il existe une branche de courant de référence qui comprend une deuxième résistance (32) pouvant être commandée et une deuxième source (30) de courant pouvant être commandée, une première borne de la deuxième résistance (32) pouvant être commandée étant reliée à la borne pour le second potentiel (VCC) d'alimentation et une première borne de la deuxième source (30) de courant pouvant être commandée étant reliée à la borne pour le premier potentiel (VEE) d'alimentation, une deuxième borne de la deuxième résistance (32) pouvant être commandée étant couplée à une deuxième borne de la deuxième source (30) de courant pouvant être commandée et il est prévu un comparateur (33) dont la première entrée (+) est reliée à la deuxième borne de la deuxième résistance (32) pouvant être commandée, dont la deuxième entrée (-) est une borne pour un potentiel (L) de comparaison et dont la sortie (35) est reliée à une entrée (18) de commande de chacune de la première et deuxième résistances (32, 13 ; 32, 14) pouvant être commandées, de sorte que la valeur de la première résistance (13 ; 14) pouvant être commandée est commandée en fonction du courant de la première source (12) de courant de telle manière que lorsque le courant de la première source de courant baisse, la valeur de résistance augmente et inversement, de sorte que la chute de tension au niveau de la première résistance pouvant être commandée est, à l'état de repos du commutateur de courant, égale à une valeur prédéterminée,
caractérisé en ce qu'un transistor (31) supplémentaire est couplé avec son trajet de courant principal entre la deuxième borne de la deuxième source (30) de courant pouvant être commandée et la deuxième borne de la deuxième résistance (32) pouvant être commandée, l'entrée de commande du transistor (31) supplémentaire étant une borne pour le signal (V1) de référence.

2. Commutateur numérique de courant présentant les caractéristiques suivantes :
(a) au moins un premier et un second transistors (10, 11) sont couplés à la première borne de chaque trajet de courant principal et sont reliés par l'intermédiaire d'une première source (12) de courant pouvant être commandée à une borne pour un premier potentiel (VEE) d'alimentation,
(b) l'entrée de commande du premier transistor (10) est une borne (17) pour un signal d'entrée, l'entrée de commande du deuxième transistor (11) est une borne pour un signal (V1) de référence,
(c) les secondes bornes des trajets de courant principaux des transistors (10, 11) sont reliées à une borne pour un second potentiel (VCC) d'alimentation,
(d) la seconde borne du trajet de courant principal de l'un au moins des transistors (10 ; 11) est reliée à une borne (15 ; 16) de signal de sortie et par l'intermédiaire d'une résistance (13 ; 14) à la borne pour le second potentiel (VCC) d'alimentation,
(e) la résistance est une première résistance pouvant être commandée, et
(f) il est prévu une branche de courant de référence qui comprend une deuxième résistance (32) pouvant être commandée, un transistor (31) supplémentaire et une deuxième source (40, 41) de courant pouvant être commandée, l'entrée de commande du transistor (31) supplémentaire étant une borne pour le signal (V1) de référence, une première borne de la deuxième résistance (32) pouvant être commandée étant reliée à la borne pour le deuxième potentiel (VCC) d'alimentation et une première borne de la deuxième source (40, 41) de courant pouvant être commandée étant reliée à la borne pour le premier potentiel (VEE) d'alimentation, une deuxième borne de la deuxième résistance (32) pouvant être commandée étant couplée par l'intermédiaire du transistor (31) supplémentaire à une deuxième borne de la deuxième source (40, 41) de courant pouvant être commandée et il est prévu un comparateur (42) dont la première entrée (+) est reliée à la deuxième borne de la deuxième résistance (32) pouvant être commandée, dont la deuxième entrée (-) est une borne pour un potentiel (L) de comparaison et dqnt la sortie est reliée à une entrée de commande de chacune des première et deuxièmes sources (12, 40, 41) de courant pouvant être commandées de sorte que la valeur de la première résistance (13, 14) et le courant de la première source (12) de courant sont commandés en fonction l'un de l'autre de telle manière que lorsque la valeur de la première résistance diminue le courant de la première source de courant augmente et inversement de sorte que la chute de tension au niveau de la première résistance est, à l'état de repos du commutateur de courant, égale à une valeur prédéterminée.

3. Commutateur de courant numérique selon la revendication 1 ou 2, caractérisé en ce que la borne (-) pour le potentiel de comparaison du comparateur (33 ; 42) est reliée à la sortie d'un circuit (47) stabilisateur de tension compensé en température.

4. Commutateur de courant numérique selon l'une des revendications 1 à 3, caractérisé en ce que les transistors (10, 11, 31) sont des transistors bipolaires.

5. Commutateur de courant numérique selon l'une des revendications 1 à 4, caractérisé en ce que les résistances pouvant être commandées sont des transistors MOS (13, 14, 32) d'un premier type de canal.

6. Commutateur de courant numérique selon la revendication 5, caractérisé en ce que les sources de courant pouvant être commandées sont des transistors MOS (20, 12, 30) d'un deuxième type de canal complémentaire du premier type de canal.

7. Commutateur de courant numérique selon l'une des revendications 1 à 6, caractérisé en ce que les sources de courant pouvant être commandées sont des transistors (40) bipolaires comportant une résistance (41) côté émetteur.
